Europäisches Patentamt

European Patent Office

Office européen des brevets

(19)

(11) Publication number: 0 449 790 A2

# (12) EUROPEAN PATENT APPLICATION

(21) Application number: 91830115.1

(22) Date of filing: 26.03.91

(51) Int. Cl.⁵: H01R 43/02

(30) Priority: 28.03.90 IT 341590

(43) Date of publication of application:
02.10.91 Bulletin 91/40

(84) Designated Contracting States:
CH DE DK FR GB LI NL SE

(71) Applicant: EQUITEC S.R.L.
Via Bonoli, 61/2
I-48022 Lugo (Ravenna) (IT)

(72) Inventor: Reggi, Romano
Via Bonoli, 61/2
I-48022 Lugo (Ravenna) (IT)

(74) Representative: Trentini, Ermanno
Studio Brevetti Internazionali Ing. E. Trentini
Via U. Lenzi, 2
I-40122 Bologna (IT)

(54) Induction welding station for contact inserting machines on hybrid circuit substrates or on traditional printed circuit cards.

(57)   Induction welding station for contact inserting machines on hybrid circuit substrates or on traditional printed circuit cards comprising a high-frequency generator and a water-cooled inductor winding, characterized in that, by means of its superimposed two-branched shaped configuration, it is capable of generating a magnetic melting field at the precise point of the tin weld material deposit in corrispondence with the clips of the pins to be welded to the substrate.

EP 0 449 790 A2

Fig. 2

Fig. 3

This invention relates to a machine for welding contact pins from strips to hybrid circuit substrates or to traditional printed circuit cards to which components of various kinds of such circuits have eventually been welded onto appropriate areas.

It is known that the major technological problem relating to this kind of machine concerns the welding of pick-up clips on the edges of the substrate. Various techniques have been employed and are still in use, including manual dipping of every single circuit or strip of circuits in a melted tin bath and ultrasonic or laser welding employing weld material in the form of wires or granules or soft solder previously deposited on the substrate.

All these procedures have been proven incapable of giving satisfactory results due to a variety of specific reasons such as the formation of needles in the case of dip welding, the fact of having to carry out only one welding at a time with other welding systems, and of having to clean the circuits of all residual weld material at end of welding operations, factors which are all aggravated by the fact of being even more difficult to perform on an industrial scale.

The present invention, which relates to an induction welding station designed for use with traditional contact inserting machines, overcomes the above-mentioned problems by providing a device capable of simultaneously welding all clips onto the substrate regardless of their location.

This is achieved by a welding electrode which can be easily shaped and adapted to all requirements, thus eliminating the need to subsequently clean the welded circuits. It is also known that induction welding exploits, for heating, the effects of the electromagnetic induction generated by a high-frequency, low-tension electric current passing through a solenoid wound around the part to be heated. This current thus generates a magnetic field which, in turn, produces induced currents in the metal located within the field. Thanks to the electric resistance thus induced, these currents then heat the material which also receives additional heat from hysteretic loss.

It is furthermore known that due to the skin effect, the current tends to flow towards the surface of the conductors and that such skin effect is all the more marked the higher the frequency of the current.

The depth of current penetration is in fact inversely proportional to the square root of the frequency. The use of high frequencies, therefore, is useful for reducing the extent of the heated area. Considering all these factors, the use of the welding technique outlined herein is particularly suited for the intended purpose, i.e. melting in a well-defined and localized area a small quantity of tin in order to weld, both mechanically and electrically, the pins to the boards without demaging the board-installed components as a consequence of heat from the welding operation.

The welding station which is the object of the present invention comprises a high-frequency generator and an inductor winding normally consisting of water-cooled silver or copper tubing. The station is so designed as to heat only the tin previously deposited on the precise bonding position thanks to the particular configuration of the winding, which, as already stated, can be easily and appropriately shaped according to requirements.

Moreover, in the case in which welding is not to be made on substrates owing to the presence of silk-screen printed tin in the precise clip fixing positions, the station also comprises a deposit for weld material in the form of paste, bars, granules or sheets located upstream of the welding unit itself.

One way of carrying out the invention is described in detail below with reference to drawings which illustrate only one specific embodiment, in which:

Figure 1, is an assembly drawing of the contact inserting machine.

Figure 2, is the inductor winding.

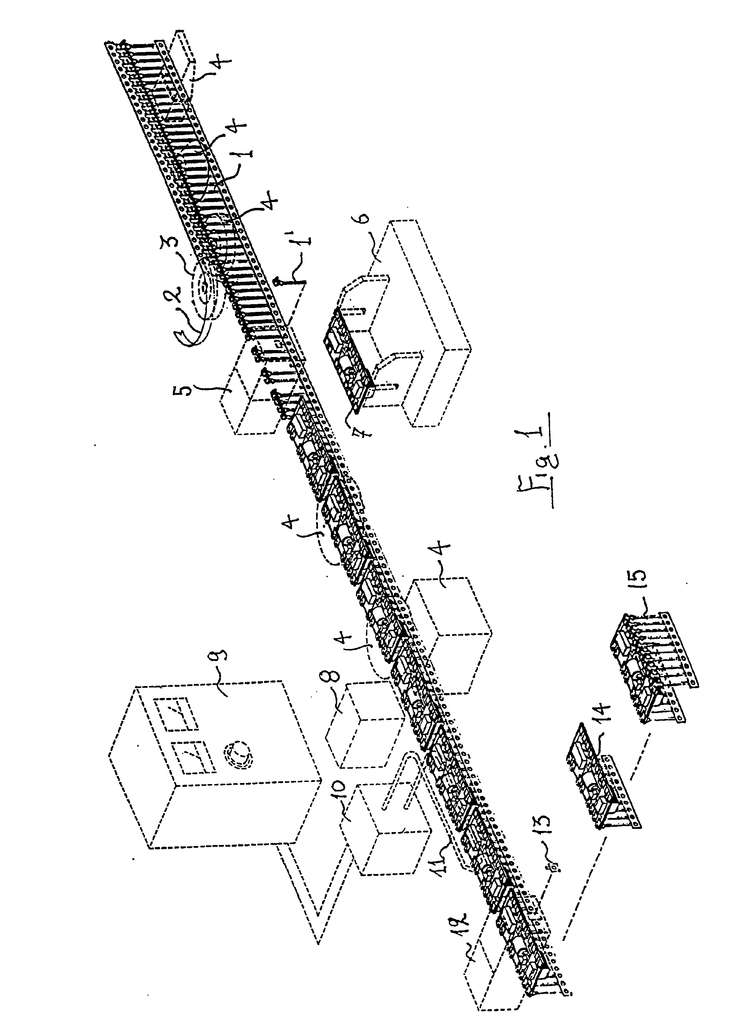

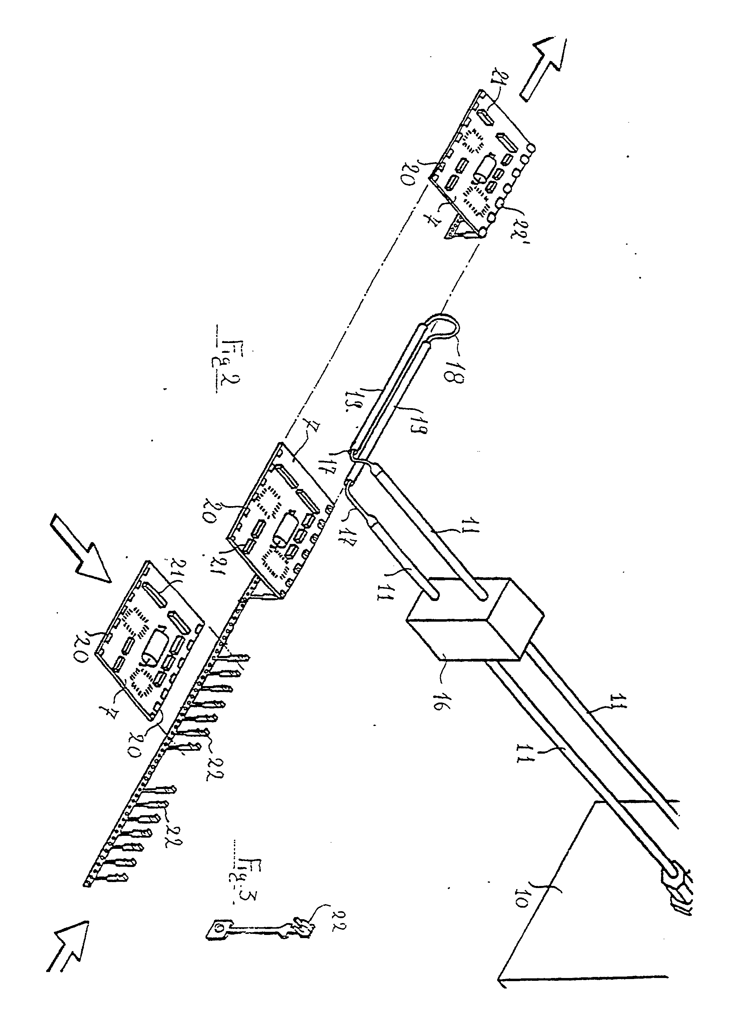

Referring now in detail to the accompanying drawings, reference numeral 1 shows the strip of pins from which the upper strip 2 is removed by the relieving tool 3 during feending, which is achieved and directed along the line by the mechanical devices 4, 5 is the ejector of pins 1' which are not required for contacts, 6 is the mobile trolley carrying substrate 7 which, moving perpendicularly to the line, inserts the substrate into the pins clips, 8 is the weld material deposit fitted in this particular embodiment of the invention but not required if the substrate has been previously prepared for welding as shown in Figure 2, 9 is the high-frequency generator, 10 is the transducer, 11 is the winding featuring appropriate shape and set in such a way as to generate a magnetic field inside which is located the weld material for welding, 12 is the cutting station which, by eliminating the lower part of strip 13, separates the single circuits which can be either of the SIL type, i.e. singular in line, featuring a single set of contacts 14, or of the DIL type, i.e. dual in line, featuring two sets of contacts 15 (the latter can be achieved by using a double line, which however is not shown in the accompanying drawings).

In Figure 2, 16 is the separator isolating element downstream of which the upper and lower branches of the inductor depart, which after a short distance diminishes in sectional dimension into 17 and sets itself at about 90° with respect to its previous lengths so as to be lined up with the direction of the hybrid circuit feed path. The welding edge of the hybrid circuit thus comes to find itself between the two branches in such a way as to be exposed to the magnetic field precisely at the tin deposit points. 18 is a configuration of the inductor which allows for the various circuits to pass beyond, even through the magnetic field, without obstructions, 19 is a winding protective covering, 20 is the silk-screen printed tin weld material, 21 are the hybrid circuit components and 22 are the clips corresponding to the upper ends of the pins 1 represented in detail in Fig. 3 which, after insertion of the substrate 7, come to coincide perfectly with the melted tin weld material on pins 22'.

## Claims

1. An induction welding station for contact inserting machines on hybrid circuit substrates or on traditional printed circuit cards comprising a high-frequency generator (9), a transducer (10) and a hollow inductor winding (11) for cooling water circulation, characterized by the fact that the length of the end part of the inductor loop (17) is approximately equal to that of the hybrid circuit or in any case a multiple thereof, having an appropriately protected upper and lower length and being shaped at about 90° with respect to the initial length coming out of the separator isolating element (17) so as to ensure easy introduction of the hybrid circuit edge which, while moving step by step, comes to find itself at the center of the magnetic field generated by the two branches of the induced field, which shall cause all tin weld material on the substrate to melt simultaneously. Also characterized by the fact that the loop (18) connecting the lower branch and the upper branch of the inducer is turned backwards in order to facilitate the passage of the edge of the hybrid circuit in case said edge is set at 90° with respect to the pin strip.

2. An induction welding station for contact inserting machines on hybrid circuit substrates or on traditional printed circuit cards as set forth in Claim 1, characterized by the fact that the shape of the inducer remains practically the same even when the pin strip is set at 180° with respect to the substrate, in which case, however, the loop is so sized as to have a depth greater than the width of the strip.

3. An induction welding station for contact inserting machines on hybrid circuit substrates or on traditional printed circuit cards as set forth in Claims 1 and 2, above, characterized by the fact that, if the machine is meant to operate without the use of substrates previously arranged for welding due to the presence of silk-screened tin weld material, a weld material deposit unit (8) is fitted upstream of the welding station.

EP 0 449 790 A2

Fig. 1

Fig.2

Fig.3